# EUROPÄISCHE PATENTSCHRIFT

(11) **EP 2 198 678 B1**
(45) Veröffentlichungstag und Bekanntmachung des Hinweises auf die Patenterteilung: **24.10.2012**
(21) Anmeldenummer: 08785486.5
(22) Anmeldetag: 11.08.2008
(51) Int. Cl.: H01P 5/08, H01R 13/11

(54) **MEHRFACH-MIKRO-HF-KONTAKTANORDNUNG**
MULTIPLE MICRO HF-CONTACT ARRANGEMENT
CONFIGURATION DE CONTACTS POUR LIGNES MICRORUBANS HF MULTIPLES

(30) Priorität: 11.09.2007 DE 202007012719 U
(43) Veröffentlichungstag der Anmeldung: 23.06.2010
(73) Patentinhaber: Rosenberger Hochfrequenztechnik GmbH & Co. KG, 83413 Fridolfing (DE)
(72) Erfinder: ROSENBERGER, Bernd, 84529 Tittmoning (DE)
(74) Vertreter: Zeitler - Volpert - Kandlbinder
(86) Internationale Anmeldenummer: PCT/EP2008/006606
(87) Internationale Veröffentlichungsnummer: WO 2009/033538

(56) Entgegenhaltungen:
- EP-A- 0 905 812
- WO-A-98/09354
- DE-A1- 2 705 621
- DE-C1- 19 544 536
- JP-A- 2001 015 880
- US-A1- 2004 080 386

## Beschreibung

Die Erfindung betrifft eine Mehrfach-Mikro-HF-Kontaktanordnung gemäß dem Oberbegriff des Anspruchs 1.

Bei bekannten Kontaktanordnungen der gattungsgemäßen Art ist häufig das Erfordernis gegeben, in einer Gehäusedurchbrechung bzw. in einem Kanal mit äußerst begrenzten Querschnittsabmessungen Hochfrequenzverbindungen durchzuführen. Hierbei kommt häufig erschwerend hinzu, dass es sich um einen Übergang von einer Koaxialleitung bzw. Microstripleitung auf eine Koplanarleitung handelt.

DE 195 44 536 C1 und US 2004/0080386 A1 offenbaren Kontaktanordnungen der bekannten Art. Der Erfindung liegt daher die Aufgabe zu Grunde, eine Mehrfach-Mikro-HF-Kontaktanordnung zu schaffen, mittels der es möglich ist, eine große Anzahl von Hochfrequenzverbindungen innerhalb eines äußerst begrenzten Raumes, beispielsweise also einer Gehäusedurchbrechung bzw. eines Kanals, zu schaffen bzw. zu ermöglichen.

Diese Aufgabe wird mit der Erfindung durch die Merkmale des Anspruchs 1 gelöst. Vorteilhafte Ausgestaltung hiervon sind in den weiteren Ansprüchen beschrieben.

Der Erfindung liegt der verblüffend einfache Gedanke zu Grunde, die Mehrfach-Mikro-HF-Kontaktanordnung für eine Gehäusedurchbrechung der zur Rede stehenden Art dadurch zu verwirklichen, dass die HF-Verbindung wenigstens zwei in einer Ebene angeordnete Leiterplatten aufweist, die wenigstens über einen planaren Kontaktstift der einen Leiterplatte und wenigstens eine planare Buchse der anderen Leiterplatte verbindbar sind.

Auf Grund des äußerst begrenzten Raumes, den eine derartige Anordnung von paarweise vorgesehenen Leiterplatten einnimmt, ist es erfindungsgemäß möglich, in der Gehäusedurchbrechung mehrere, ja sogar eine Vielzahl von Leiterplattenpaaren anzuordnen.

Die Anzahl der vorzusehenden HF-Verbindungen kann erfindungsgemäß noch dadurch drastisch gesteigert werden, dass jedes Leiterplattenpaar eine Vielzahl von Kontaktstift-Buchsenanordnungen aufweist.

In Ausgestaltung der Erfindung ist vorgesehen, dass jeder planare Kontaktstift der einen Leiterplatte als verlängerte Kontaktlasche, insbesondere zum Zweck des Toleranzausgleichs, ausgebildet ist.

Hierbei liegt es auch im Rahmen der Erfindung, dass jeder Kontaktstift eine planare Kontaktlasche mit einer Erhebung aufweist, um auf diese Weise die Kontaktierung mit der planaren Buchse zu erleichtern bzw. in jedem Fall sicherzustellen.

Es ist erfindungsgemäß von Vorteil, wenn jede planare Buchse der anderen Leiterplatte beispielsweise als U-förmiges Bauteil mit zwei Kontaktschenkeln zur federnden Aufnahme eines Kontaktstiftes ausgebildet ist.

Zweckmäßigerweise weisen die Kontaktschenkel der planaren Buchse an oder nahe ihrem offenen Ende nach innen ragende Vorsprünge zur intensiven Kontaktierung mit einem Kontaktstift auf.

Vorteilhafterweise sind sowohl planarer Kontakstift als auch planare Buchse mit jeweils einer, vorzugsweise einstückigen, Basis an der zugeordneten Leiterplatte befestigt.

Besondere Vorteile ergeben sich hierbei, wenn die Basis jedes Kontaktstiftes und/oder jeder planaren Buchse an oder nahe ihrer Befestigungsstelle an der Leiterplatte eine, insbesondere dem Toleranzausgleich dienende, Sollbiegestelle, beispielsweise in Form eines geschwächten Basisquerschnitts, aufweist.

Die Erfindung wird im Folgenden an Hand der Zeichnungen näher erläutert. Hierbei zeigen:
- Fig. 1: schematisch in perspektivischer Darstellung eine Mehrfach-Mikro-HF-Kontaktanordnung mit einem in einer Gehäusedurchbrechung angeordneten einzigen Leiterplattenpaar;
- Fig. 2: die HF-Verbindung zweier Leiterplatten in Draufsicht; und
- Fig. 3: in Seitenansicht;
- Fig. 4: schematisch perspektivisch ein in einer Gehäusedurchbrechung angeordnetes Leiterplattenpaar mit einer Vielzahl von HF-Verbindungen, und
- Fig. 5: perspektivisch eine Vielzahl von in einer Gehäusedurchbrechung angeordneten Leiterplattenpaaren mit jeweils einer Vielzahl von HF-Verbindungen.

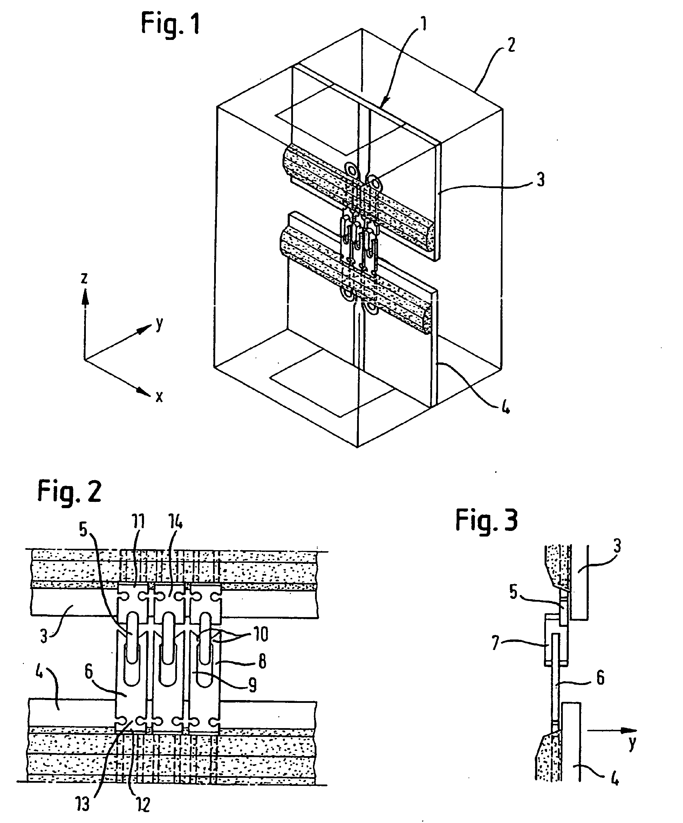

Wie aus der Zeichnung, insbesondere aus Fig. 1, 4 und 5, ersichtlich, ist die dargestellte Mehrfach-Mikro-HF-Kontaktanordnung 1 zum Einbau bzw. zur Anordnung in einer Gehäusedurchbrechung 2 von typischerweise äußerst begrenzten Querschnittsausmaßen vorgesehen.

Hierbei handelt es sich bei der dargestellten Kontaktanordnung um den Übergang von einer Koaxialleitung bzw. Microstripleitung auf eine Koplanarleitung.

Wie deutlich aus Fig. 1 bis 3 ersichtlich, weist die dargestellte Kontaktanordnung 1 wenigstens zwei Leiterplatten 3, 4 auf, die in einer parallelen Ebene, im vorliegenden Fall z-Ebene gemäß Fig. 1, angeordnet sind und die über wenigstens einen planaren Kontaktstift 5 der einen Leiterplatte 3 sowie über wenigstens eine planare Buchse 6 der anderen Leiterplatte 4 miteinander verbindbar sind.

Auf Grund dieser Ausbildung ist es möglich, dass jedes Leiterplattenpaar 3, 4, eine Vielzahl von Kontaktstift-Buchsenanordnungen 5, 6, aufweisen kann, wie deutlich aus Fig. 2, 4 und 5 ersichtlich.

Zur Durchführung einer sicheren HF-Verbindung ist jeder planare Kontaktstift 5 der einen Leiterplatte 3 als verlängerte Kontaktlasche ausgebildet. Dies dient dem erwünschten Toleranzausgleich in z-Richtung der Kontaktanordnung.

Zusätzlich hierzu ist die planare Kontaktlasche jedes Kontaktstiftes 5 mit einer Erhebung 7 versehen, um auf diese Weise die Kontaktierung des Kontaktstiftes 5 mit der planaren Buchse 6 bzw. dessen Einfürhung in die planare Buchse 6 zu erleichtern und sicherzustellen.

Die Ausbildung jeder planaren Buchse 6 der anderen Leiterplatte 4 ist derart vorgesehen, dass sie als U-förmiges Bauteil mit zwei Kontaktschenkeln 8, 9 gestaltet ist, die zur federnden Aufnahme eines zugeordneten Kontaktstiftes 5 dienen.

Wie hierbei deutlich aus Fig. 2 ersichtlich, weisen die Kontaktschenkel 8, 9 der planaren Buchse 6 an ihrem offenen Ende nach innen ragende Vorsprünge 10 auf, die der intensiven - und auch federnden - Kontaktierung mit einem Kontaktstift 5 dienen.

Wie weiterhin aus Fig. 2 ersichtlich, ist von besonderer Bedeutung, dass sowohl jeder planare Kontaktstift 5 als auch jede planare Buchse 6 eine einstückige Basis 11 bzw. 12 aufweisen, mittels welcher sie in der dargestellten Weise an der zugeordneten Leiterplatte 3 bzw. 4 befestigt sind.

Hierbei weist die Basis 11 bzw. 12 jedes Kontaktstiftes 5 und jeder planaren Buchse 6 an der betreffenden Befestigungsstelle eine Sollbiegestelle 13 bzw. 14 in Form eines geschwächten Querschnitts auf. Dies dient, wie dargestellt, dem vorteilhaften Toleranzausgleich in x-Richtung (siehe Fig. 1).

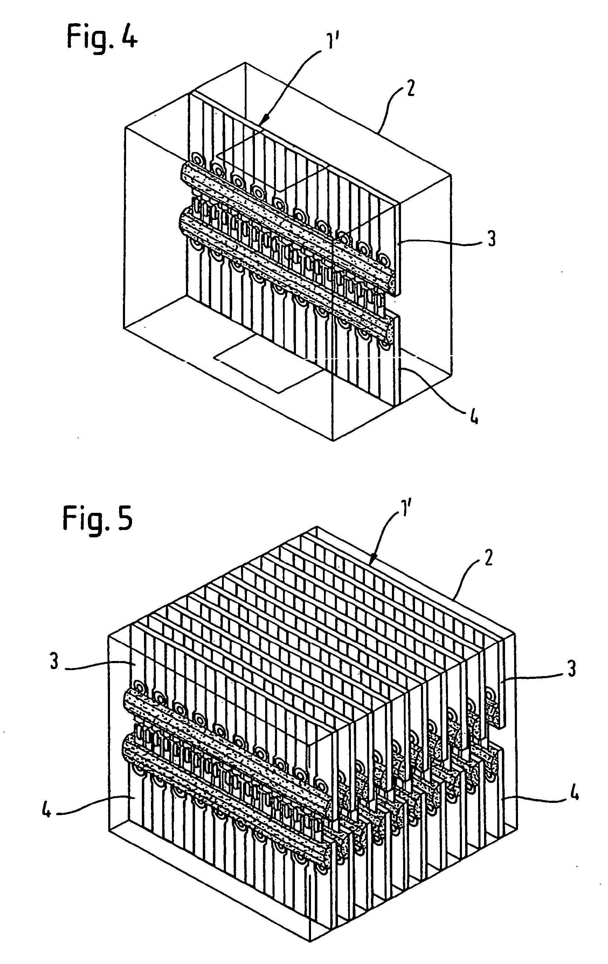

Bei der abgewandelten Ausführungsform gemäß Fig. 4 besteht die dargestellte Kontaktanordnung 1 aus einem Leiterplattenpaar 3, 4, das eine Vielzahl von HF-Verbindungen 5, 6 der beschriebenen Art aufweist.

In entsprechender Weise ist schließlich bei der weiterhin abgewandelten Ausführungsform gemäß Fig. 5 in der Gehäusedurchbrechung 2 eine Vielzahl von Leiterplattenpaaren 3, 4 vorgesehen, die jeweils mittels der beschriebenen Kontaktstift-Buchsenanordnung 5, 6 verbunden sind.

Hinsichtlich vorstehend nicht näher erläuterter Merkmale der Erfindung wird ausdrücklich auf die Zeichnungen sowie die Ansprüche verwiesen.

## Patentansprüche

1. Mehrfach-Mikro-HF-Kontaktanordnung mit in einer Gehäusedurchbrechung (2) bzw. in einem Kanal hindurchzuführenden bzw. zu kontaktierenden HF-Verbindungen, insbesondere beim Übergang von Koaxialleitung bzw. Microstripleitung auf Koplanarleitung,
**dadurch gekennzeichnet,**
**dass** die HF-Verbindung wenigstens zwei in einer Ebene angeordnete Leiterplatten (3, 4) aufweist, die wenigstens über einen planaren Kontaktstift (5) der einen Leiterplatte (3) und wenigstens eine planare Buchse (6) der anderen Leiterplatte (4) miteinander verbindbar sind.

2. Kontaktanordnung nach Anspruch 1, **dadurch gekennzeichnet, dass** in der Gehäusedurchbrechung (2) mehrere Leiterplattenpaare (3, 4) anordenbar sind.

3. Kontaktanordnung nach Anspruch 1 oder 2, **dadurch gekennzeichnet, dass** jedes Leiterplattenpaar (3, 4) eine Vielzahl von Kontaktstift-Buchsenanordnungen (5, 6) aufweist.

4. Kontaktanordnung nach einem der vorhergehenden Ansprüche, **dadurch gekennzeichnet, dass** jeder planare Kontaktstift (5) der einen Leiterplatte (3) als verlängerte Kontaktlasche, insbesondere zum Toleranzausgleich, ausgebildet ist.

5. Kontaktanordnung nach einem der vorhergehenden Ansprüche, **dadurch gekennzeichnet, dass** jeder Kontaktstift (5) eine planare Kontaktlasche mit einer Erhebung (7) aufweist.

6. Kontaktanordnung nach einem der vorhergehenden Ansprüche, **dadurch gekennzeichnet, dass** jede planare Buchse (6) der anderen Leiterplatte (4) als U-förmiges Bauteil mit zwei Kontaktschenkeln (8, 9) zur federnden Aufnahme eines Kontaktstiftes (5) ausgebildet ist.

7. Kontaktanordnung nach Anspruch 6, **dadurch gekennzeichnet, dass** die Kontaktschenkel (8, 9) der planaren Buchse (6) an oder nahe ihrem offenen Ende nach innen ragende Vorsprünge (10) zur intensiven Kontaktierung mit einem Kontaktstift (5) aufweisen.

8. Kontaktanordnung nach einem der vorhergehenden Ansprüche, **dadurch gekennzeichnet, dass** sowohl planarer Kontaktstift (5) als auch planare Buchse (6) mit jeweils einer, vorzugsweise einstückigen, Basis (11, 12) an der zugeordneten Leiterplatte (3, 4) befestigt sind.

9. Kontaktanordnung nach Anspruch 8, **dadurch gekennzeichnet, dass** die Basis (11, 12) jedes Kontaktstiftes (5) und/oder jeder planaren Buchse (6) an oder nahe ihrer Befestigungsstelle an der Leiterplatte (3, 4) eine, insbesondere dem Toleranzausgleich dienende, Sollbiegestelle (13, 14), beispielsweise in Form eines geschwächten Basisquerschnitts, aufweist.

## Claims

1. Multiple RF micro-contact arrangement having RF connections which are to be run through or which are to make contact in a housing aperture (2) or in a passage, particularly at the transition from a coaxial line or microstrip line to a coplanar line, **characterised in that** the RF connection has at least two printed circuit boards (3, 4), arranged in a plane, which can be connected together by means of at least one planar contact pin (5) belonging to one printed circuit board (3) and at least one planar socket (6) belonging to the other printed circuit board (4).

2. Contact arrangement according to claim 1, **characterised in that** a plurality of pairs of printed circuit boards (3, 4) can be arranged in the housing aperture (2).

3. Contact arrangement according to claim 1 or 2, **characterised in that** each pair of printed circuit boards (3, 4) has a plurality of contact pin and socket arrangements (5, 6).

4. Contact arrangement according to one of the foregoing claims, **characterised in that** each planar contact pin (5) belonging to the one printed circuit board (3) takes the form of an extended contacting lug, particularly for compensating for tolerances.

5. Contact arrangement according to one of the foregoing claims, **characterised in that** each contact pin (5) has a planar contacting lug which has an elevation (7).

6. Contact arrangement according to one of the foregoing claims, **characterised in that** each planar socket (6) belonging to the other printed circuit board (4) takes the form of a U-shaped component having two contacting arms (8, 9) for the resilient reception of a contact pin (5).

7. Contact arrangement according to claim 6, **characterised in that** the contacting arms (8, 9) of the planar socket (6) have inwardly projecting projections (10) at or close to their open end to allow stronger contact to be made with a contact pin (5).

8. Contact arrangement according to one of the foregoing claims, **characterised in that** both the planar contact pin (5) and also the planar socket (6) are fastened to the associated printed circuit boards (3, 4) by respective, preferably integral, bases (11, 12).

9. Contact arrangement according to claim 8, **characterised in that** the base (11, 12) of each contact pin (5) and/or of each planar socket (6) has, at or close to the point at which it is fastened to the printed circuit board (3, 4), an intended bend-point (13, 14), in the form of a weakened cross-section of the base for example, which serves in particular to compensate for tolerances.

## Revendications

1. Agencement multiple de microcontacts HF comprenant des jonctions HF à faire traverser ou à mettre en contact dans une traversée (2) d'un boîtier ou dans un canal, en particulier à la transition d'une ligne coaxiale ou d'une ligne à microbande vers une ligne coplanaire,
**caractérisé en ce que**
la jonction HF comprend au moins deux cartes à circuits (3, 4) agencées dans un plan, lesquelles peuvent être reliées l'une à l'autre via au moins une broche de contact plane (5) de l'une des cartes à circuits (3) et au moins une douille plane (6) de l'autre carte à circuits (4).

2. Agencement de contacts selon la revendication 1, **caractérisé en ce que** plusieurs paires de cartes à circuit (3, 4) sont susceptibles d'être agencées dans la traversée (2) du boîtier.

3. Agencement de contacts selon la revendication 1 ou 2, **caractérisé en ce que** chaque paire de cartes à circuits (3, 4) comprend une pluralité d'agencements composés d'une broche de contact et d'une douille (5, 6).

4. Agencement de contact selon l'une des revendications précédentes, **caractérisé en ce que** chaque broche de contact plane (5) de l'une des cartes à circuits (3) est réalisée sous forme de patte de contact prolongée, en particulier pour la compensation des tolérances.

5. Agencement de contact selon l'une des revendications précédentes, **caractérisé en ce que** chaque broche de contact (5) comprend une patte de contact plane avec une bosse (7).

6. Agencement de contact selon l'une des revendications précédentes, **caractérisé en ce que** chaque douille plane (6) de l'autre carte à circuits (4) est réalisée comme un composant en forme de U avec deux branches de contact (8, 9) pour la réception d'une broche de contact (5) avec effet ressort.

7. Agencement de contact selon la revendication 6, **caractérisé en ce que** les branches de contact (8, 9) de la douille plane (6) comportent à leur extrémité ouverte ou à proximité de cette extrémité des saillies dirigées vers l'intérieur (10) pour venir en contact intime avec une broche de contact (5).

8. Agencement de contact selon l'une des revendications précédentes, **caractérisé en ce que** la broche de contact plane (5) tout comme la douille plane (6) sont fixées chacune avec une base (11, 12), de préférence d'un seul tenant, sur la carte à circuits associée (3, 4).

9. Agencement de contact selon la revendication 8, **caractérisé en ce que** la base (11, 12) de chaque broche de contact (5) et/ou de chaque douille plane (6) comporte, au niveau ou à proximité de son emplacement de fixation sur la carte à circuits (3, 4), un emplacement de flexion de consigne (13, 14), servant en particulier à la compensation de tolérances, par exemple sous la forme d'un affaiblissement de la section de base.
